# FASCICULE DE BREVET EUROPEEN

(11) **EP 2 304 872 B1**
(45) Date de publication et mention de la délivrance du brevet: **28.02.2018**
(21) Numéro de dépôt: 09772759.8
(22) Date de dépôt: 06.07.2009
(51) Int. Cl.: H03F 3/45, G01L 9/06, G01R 27/16

(54) **CIRCUIT D'AMPLIFICATION D'UN SIGNAL REPRÉSENTANT UNE VARIATION DE RÉSISTANCE D'UNE RÉSISTANCE VARIABLE ET CAPTEUR CORRESPONDANT**
SCHALTUNG ZUM VERSTÄRKEN EINES SIGNALS, DAS EINE WIDERSTANDSSCHWANKUNG EINES VARIABLEN WIDERSTANDS UND ENTSPRECHENDEN KONDENSATORS REPRÄSENTIERT
CIRCUIT FOR AMPLIFYING A SIGNAL REPRESENTING A VARIATION IN RESISTANCE OF A VARIABLE RESISTANCE AND CORRESPONDING CAPACITOR

(30) Priorité: 04.07.2008 FR 0854585
(43) Date de publication de la demande: 06.04.2011
(73) Titulaire: Centre National de la Recherche Scientifique (C.N.R.S.), 75016 Paris (FR); Université de Montpellier, 34090 Montpellier (FR)
(72) Inventeur: BOUJAMAA, El Mehdi, F-34090 Montpellier (FR); NOUET, Pascal, F-34980 Combaillaux (FR); MAILLY, Frédérick, F-34980 Montferrier-sur-Lez (FR); LATORRE, Laurent, F-34270 Claret (FR)
(74) Mandataire: Lavoix
(86) Numéro de dépôt international: PCT/FR2009/051324
(87) Numéro de publication internationale: WO 2010/001077

(56) Documents cités:
- EP-A- 0 496 147
- US-A- 5 610 557
- US-A1- 2002 053 916
- AKIYAMA: "Integrated MR sensors for automobile" IEEE TRANSACTIONS ON MAGNETICS, vol. 30, no. 6, 6 avril 1994 (1994-04-06), pages 4617-4619, XP002512844

## Description

La présente invention concerne un circuit d'amplification d'un signal représentant une variation de résistance d'une résistance variable.

Elle concerne également un capteur comportant un tel circuit d'amplification.

Plus particulièrement, l'invention se rapporte aux capteurs dits résistifs, c'est-à-dire comportant au moins une résistance variable comme élément sensible de mesure.

Le document US 6,598,484 décrit un dispositif de détection comportant un montage différentiel intégrant des première et seconde résistances qui varient en fonction d'une grandeur physique à mesurer. La mesure de la différence entre les tensions aux bornes de ces résistances polarisées par des courants adaptés est représentative de la grandeur physique.

Par ailleurs, dans le domaine technique des amplificateurs opérationnels, le document US 5 610 557 divulgue un circuit de réduction d'offset comportant une première charge raccordée à l'électrode de sortie d'un premier transistor, l'électrode d'entrée du premier transistor étant raccordée directement à une première résistance ajustable et son électrode de commande étant raccordée directement, à la fois, à l'électrode de commande et à l'électrode de sortie d'un deuxième transistor, l'électrode d'entrée du deuxième transistor étant raccordée directement à une seconde résistance ajustable et son électrode de sortie étant raccordée à une deuxième charge, la première charge comportant un troisième transistor dont l'électrode de sortie est raccordée à l'électrode de sortie du premier transistor et la deuxième charge comportant un quatrième transistor dont l'électrode de sortie est raccordée à l'électrode de sortie du deuxième transistor.

Durant ces vingt dernières années, l'émergence des technologies MEMS (« MicroElectroMechanical Systems ») a rendu possible l'intégration de capteurs au sein de systèmes complexes de taille réduite. En effet il est désormais possible d'envisager l'intégration monolithique de systèmes hétérogènes à l'aide de technologies standard CMOS, comprenant la partie sensible du capteur ainsi que son électronique de traitement. L'intégration de l'électronique de traitement au plus près de l'élément sensible permet ainsi une diminution notable des coûts de réalisation tout en améliorant les performances des capteurs, notamment par un traitement approprié du bruit.

Quelques-uns de ces capteurs se retrouvent ainsi dans des dispositifs tels que des téléphones mobiles, des GPS, des ordinateurs portables, etc.

Cependant, une contrainte majeure quant à l'utilisation de capteurs dans ces applications fonctionnant généralement sur batterie est liée à leur consommation. En raison de cette contrainte, la plupart des capteurs développés de nos jours sont basés sur des modes de transduction capacitifs limitant ainsi la consommation mais par la même occasion complexifiant lourdement la conception de l'élément sensible. Cette complexité de réalisation de l'élément sensible se répercute donc sur le prix final du produit.

L'un des moyens de diminuer le prix de revient d'un capteur est l'utilisation d'une technologie de transduction qui permet de diminuer la complexité structurelle du capteur. La transduction résistive répond bien à ce problème, mais les structures de conditionnement de signal les plus utilisées consomment à ce jour beaucoup de courant. Le but de l'invention est de résoudre ce problème.

Plus particulièrement, l'invention vise à fournir des structures électroniques permettant le conditionnement de signaux issus de capteurs résistifs, ayant des performances comparables aux capteurs à transduction capacitive.

A cet effet, l'invention a pour objet un circuit conforme aux revendications.

Ainsi, l'invention permet de pallier les inconvénients des circuits usuels de conditionnement des signaux issus de capteurs résistifs en permettant de diminuer la consommation en courant de ces circuits tout en garantissant un niveau de signal de sortie acceptable et une bande passante non dégradée.

L'invention permet ainsi d'utiliser des capteurs résistifs intégrés au sein de systèmes complexes de taille réduite au lieu de capteurs capacitifs plus complexes à réaliser et plus coûteux.

On va maintenant décrire des modes de réalisation de l'invention de façon plus précise mais non limitative en regard des dessins annexés sur lesquels :
- la Figure 1 est un schéma synoptique illustrant la structure d'un circuit d'amplification de l'état de la technique ;
- la Figure 2 est un schéma synoptique illustrant une variante de la structure du circuit d'amplification de la Figure 1 ;
- la Figure 3 est un schéma synoptique illustrant un premier exemple d'un circuit d'amplification de l'état de la technique ;
- la Figure 4 est un schéma synoptique illustrant un second exemple d'un circuit d'amplification de l'état de la technique ;
- la Figure 5 est un schéma synoptique illustrant la structure d'un circuit d'amplification selon l'état de la technique ;
- la Figure 6 est un schéma synoptique illustrant la structure d'un circuit d'amplification selon un premier mode de réalisation de l'invention ;
- la Figure 7 est un schéma synoptique illustrant la structure d'un circuit d'amplification selon un second mode de réalisation de l'invention ;
- la Figure 8 est un schéma synoptique illustrant la structure d'un circuit d'amplification selon l'état de la technique ;
- la Figure 9 est un schéma synoptique illustrant la structure d'un circuit d'amplification selon un troisième mode de réalisation de l'invention ;
- la Figure 10 est un schéma synoptique illustrant la structure d'un circuit d'amplification selon un quatrième mode de réalisation de l'invention ;
- la Figure 11 est un schéma synoptique illustrant la structure d'un circuit d'amplification selon l'état de la technique ;
- la Figure 12 est un schéma synoptique illustrant la structure d'un circuit d'amplification selon un cinquième mode de réalisation de l'invention ; et
- la Figure 13 est un schéma synoptique illustrant la structure d'un circuit d'amplification selon un sixième mode de réalisation de l'invention.

Par définition, un capteur résistif convertit le mesurande (grandeur physique à mesurer) en une variation de résistance. La suite de la description se concentre sur les capteurs piézorésistifs qui constituent un sous-ensemble des capteurs résistifs dans lequel le mesurande entraîne une déformation mécanique d'un corps d'épreuve qui donne lieu à une contrainte puis à une variation de résistance. La transduction est réalisée grâce à des jauges dites de contrainte pouvant être fabriquées à l'aide de matériaux disposant de propriétés piézorésistives. D'un point de vue « système », ces jauges sont des résistances dont on cherche à mesurer la valeur, à l'aide d'un circuit de conditionnement ou de polarisation et de mesure.

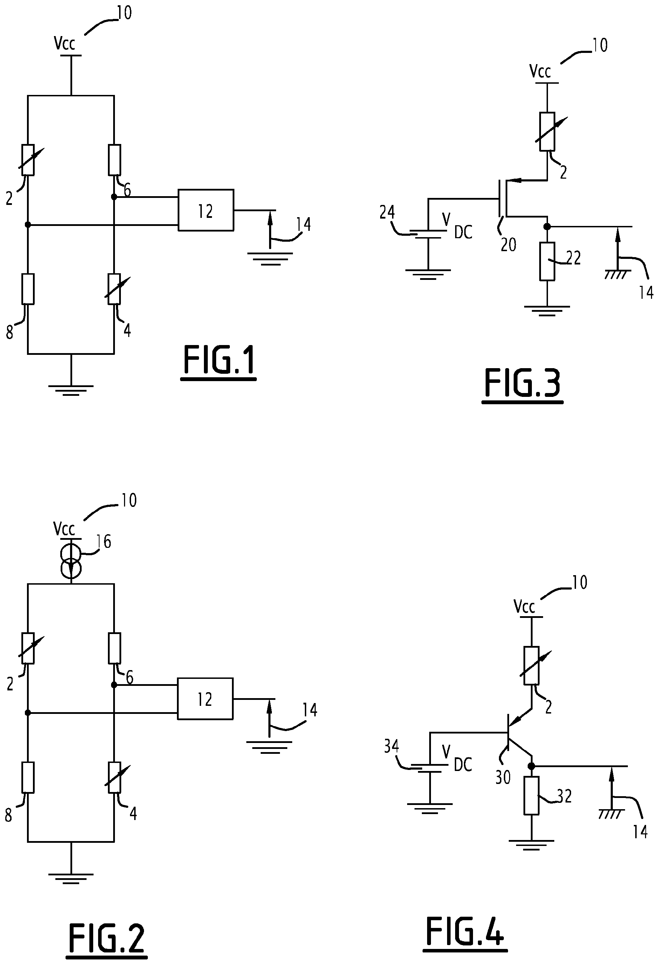

La Figure 1 illustre la structure de conditionnement de capteurs piézorésistifs la plus communément utilisée.

Sur cette Figure 1, le capteur de mesure est un capteur piézorésistif comprenant deux résistances variables 2 et 4 de même valeur moyenne R et un circuit d'amplification du signal représentant la variation ΔR des résistances 2 et 4. Ce circuit consiste en un pont de Wheatstone constitué des résistances variables 2 et 4 et de deux résistances de référence 6 et 8 dont les valeurs de résistance sont égales à R. Le pont de Wheatstone ainsi constitué est alimenté par un générateur de tension V_{CC} 10.

Dans un mode de réalisation particulier, le pont de Wheatstone comprend un amplificateur à faible bruit 12 permettant d'amplifier l'amplitude du signal de sortie issu du pont de Wheatstone afin d'obtenir un signal de sortie amplifié 14.

L'amplificateur à faible bruit 12 est particulièrement utilisé dans les applications mettant en oeuvre des capteurs de type MEMS de faible sensibilité.

Le gros désavantage dont souffre le pont de Wheatstone illustré sur la Figure 1 est sa consommation. En effet, le courant consommé par le pont de Wheatstone est V_{CC}/R avec une valeur de R qui est en général égale à quelques kilos Ohms. Par conséquent le courant consommé intrinsèquement par le pont est de quelques milliampères, rendant ainsi difficile l'utilisation d'un tel dispositif dans des applications portables pour lesquelles la dissipation de puissance est un point critique. Un des moyens de diminuer la consommation du pont de Wheatstone est l'utilisation de résistances de plus grandes valeurs, entraînant ainsi une diminution de la résolution intrinsèque du capteur. En effet, le bruit intrinsèque généré par une résistance est directement proportionnel à la racine carrée de sa valeur. Ceci devient problématique dans des applications à très faible sensibilité, où le signal utile délivré par le capteur est très proche du bruit intrinsèque de l'élément sensible.

Une autre façon de réduire la consommation du pont résistif est de l'alimenter uniquement pendant un certain laps de temps. Ainsi la valeur moyenne du courant consommé est proportionnelle au rapport du temps pendant lequel le pont est alimenté sur le temps pendant lequel il n'est pas alimenté (rapport cyclique de la tension d'alimentation du pont de Wheatstone). Cette action a cependant pour effet de dégrader la bande passante du capteur. En effet, le signal de sortie ne pouvant être lu que pendant la phase d'alimentation du pont, la fréquence maximale du système échantillonné est alors la fréquence de Nyquist divisée par deux.

La Figure 2 illustre une variante de la structure du circuit de la Figure 1 dans laquelle le pont de Wheatstone est alimenté par un générateur de courant I_{BIAS} 16 au lieu du générateur de tension V_{CC} 10.

Le courant consommé par le pont de Wheatstone est alors I*_{BIAS}* au lieu de V_{cc}/R pour un pont de Wheatstone alimenté en tension. Par conséquent en fixant une faible valeur de courant, la dissipation globale de puissance est fortement réduite. L'inconvénient de ce type de polarisation est le niveau de sortie du signal. En effet le signal de sortie du pont de Wheatstone est directement proportionnel au courant traversant les résistances sensibles 2 et 4. En réduisant donc ce courant, le niveau du signal de sortie 14 est réduit.

L'invention permet de résoudre les problèmes des circuits de conditionnement des Figures 1 et 2 fondés sur l'utilisation d'un pont de Wheatstone passif composé uniquement de résistances en proposant un circuit d'amplification consommant un faible courant tout en garantissant un niveau de signal de sortie acceptable et une bande passante non dégradée.

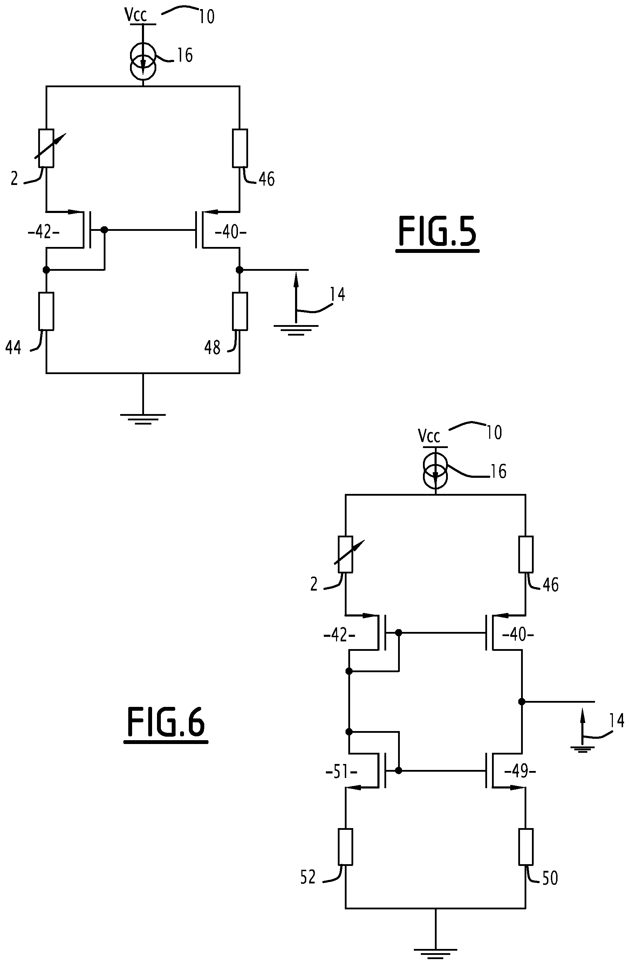

Différents modes de réalisation du circuit d'amplification selon l'invention sont décrits dans la suite de la description en référence aux Figures 6, 7, 9, 10, 11 et 12.

La Figure 3 illustre un premier exemple de réalisation d'un circuit de l'état de la technique. Le circuit illustré sur la Figure 3 comprend un transistor à effet de champ P-MOS 20 dont la source est raccordée à la résistance variable 2 représentant l'élément sensible du capteur résistif dont on souhaite récupérer le signal. Le drain du transistor 20 est raccordé à une charge constituée d'une résistance de référence R₁ désignée par la référence 22 aux bornes de laquelle est récupéré le signal amplifié 14. La grille du transistor 20 est raccordée à un générateur de tension continue V_{DC} 24.

La variation ΔR de la résistance variable 2 provoque une variation de tension sur la source du transistor 20 permettant ainsi une modulation de la tension grille-source V_{GS} autour d'un point de fonctionnement.

Le courant consommé par le circuit de la Figure 3 est de l'ordre d'une centaine de microampères pour une valeur de résistance de la résistance variable 2 égale à 1 KΩ. Ainsi, la consommation en courant de ce circuit est beaucoup plus faible que celles des structures du pont de Wheatstone classiques des Figures 1 et 2. La consommation du courant sera d'autant plus réduite que la valeur moyenne de la résistance variable 2 sera élevée.

La Figure 4 illustre un second exemple de réalisation d'un circuit de l'état de la technique.

Le circuit illustré sur la Figure 4 comprend un transistor bipolaire PNP 30 dont l'émetteur est raccordé à la résistance variable 2.

Le collecteur du transistor 30 est raccordé à une charge constituée d'une résistance de référence R₁ désignée par la référence 32 aux bornes de laquelle est récupéré le signal amplifié 14.

La base du transistor 30 est raccordée à un générateur de tension continue V_{DC} 34.

La variation ΔR de la résistance variable 2 provoque une variation de tension sur l'émetteur du transistor 30 permettant ainsi une modulation de la tension base-émetteur V_{BE} autour d'un point de fonctionnement.

Les structures des Figures 3 et 4 sont équivalentes en termes de fonctionnement. Par conséquent, les circuits décrits dans la suite de la description concernent des circuits utilisant des transistors MOS mais ils peuvent être reproduits à l'aide de transistors bipolaires en faisant l'analogie entre le transistor MOS et le transistor bipolaire où la source est équivalente à l'émetteur, le drain est équivalent au collecteur et la grille est équivalente à la base.

Par ailleurs, bien que les circuits décrits utilisent des transistors PMOS (PNP), d'autres circuits, non représentés, utilisent des structures duales NMOS (NPN).

Les structures proposées dans les circuits des Figures 3 et 4 présentent un problème qui est la réjection des grandeurs d'influences. En effet, le capteur piézorésistif peut être utilisé dans des environnements assez contraints (température, humidité...) pouvant conduire à une variation de résistance des éléments sensibles qui n'est pas due à la variation de la grandeur physique que l'on cherche à mesurer. Ainsi, une augmentation de la température, par exemple, peut engendrer une variation de la tension de sortie 14 des circuits des Figures 3 et 4.

Afin de résoudre ce problème, les circuits décrits en référence aux Figures 5 à 10 correspondent à des déclinaisons de la structure de la Figure 3 pour l'utiliser en mode différentiel.

Le générateur de courant Ibias 16 représenté sur ces figures 5 à 11 est optionnel et n'est pas indispensable pour le fonctionnement des circuits de ces figures.

La Figure 5 illustre un circuit d'amplification de l'état de la technique fonctionnant en mode différentiel. Ce circuit comprend un premier transistor MOS 40 dont la grille est raccordée à la grille et au drain d'un deuxième transistor MOS 42.

La source du deuxième transistor 42 est raccordée à la résistance variable 2 et son drain est raccordé à une charge constituée d'une résistance 44.

La source du premier transistor 40 est raccordée à une résistance de référence 46 et son drain est raccordé à une charge constituée d'une résistance 48 pouvant être choisie de même résistance que la résistance 44. La tension de sortie 14 correspondant au signal amplifié est récupérée aux bornes de la charge constituée par la résistance 48.

L'intérêt de ce circuit consiste en ce que, en l'absence de signal utile, s'il existe une grandeur d'influence, celle-ci impactera la résistance variable 2 et la résistance de référence 46 de la même manière, et la tension de sortie du montage ne variera pas.

La Figure 6 illustre un premier mode de réalisation de l'invention, qui est une variante du circuit de la Figure 5, dans lequel la première charge raccordée au drain du transistor MOS 40 est constituée d'un transistor MOS 49 en série avec une résistance 50 et la deuxième charge raccordée au drain du transistor MOS 42 est constituée d'un transistor MOS 51 en série avec une résistance 52.

Selon un mode de réalisation particulier, les résistances 46, 50 et 52 ont la même résistance. Un tel montage permet d'obtenir un gain bien supérieur à celui du montage de la Figure 5.

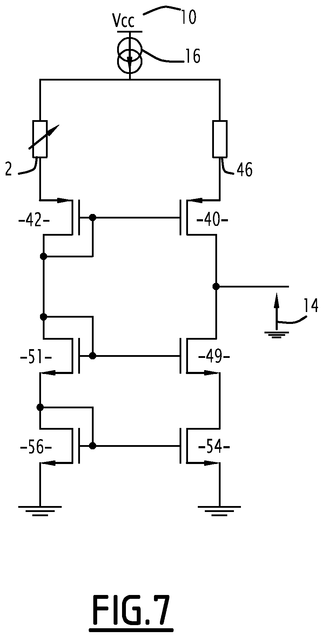

La figure 7 illustre un second mode de réalisation de l'invention, qui est une variante du mode de réalisation de la figure 6, dans lequel les résistances 50 et 52 sont remplacées respectivement par des transistors MOS 54 et 56 formant un miroir de courant.

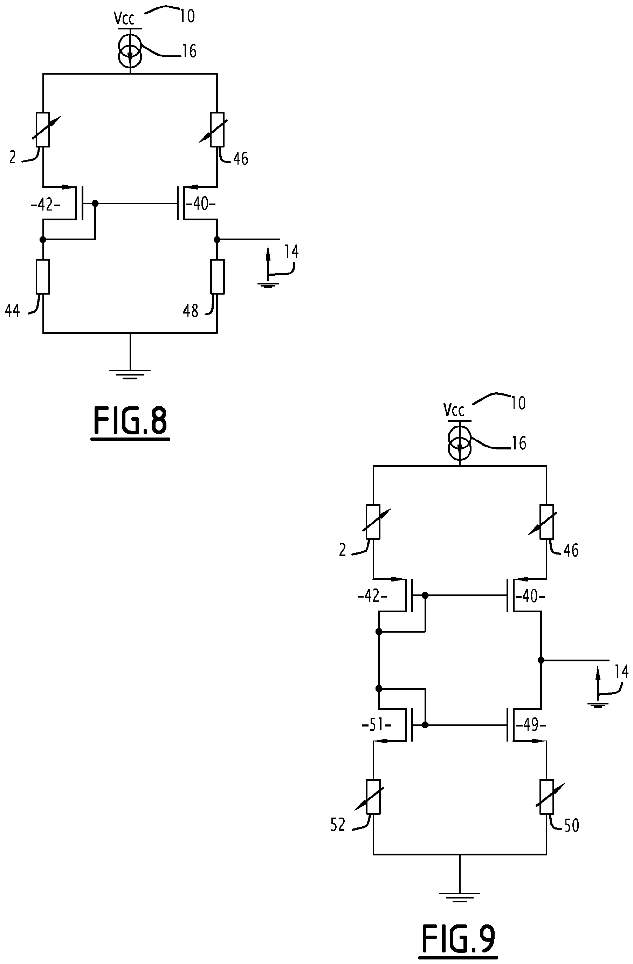

Les circuits illustrés en référence aux Figures 8 et 9 correspondent respectivement à ceux des Figures 5 et 6 dans lesquels la résistance de référence 46 est une résistance variable de valeur moyenne R. A titre d'exemple, dans le cas d'un inclinomètre possédant deux résistances sensibles R+ΔR et R-ΔR, la résistance 2 est R + ΔR et la résistance de référence 46 est R-ΔR.

Selon le troisième mode de réalisation de l'invention illustré sur la Figure 9, les résistances 50 et 52 des charges sont également variables. A titre d'exemple, la résistance 52 est R-ΔR et la résistance 50 est R+ΔR.

Les circuits des Figures 8 et 9 ont l'avantage de multiplier le gain par le nombre d'éléments sensibles (résistances variables) présents dans le circuit.

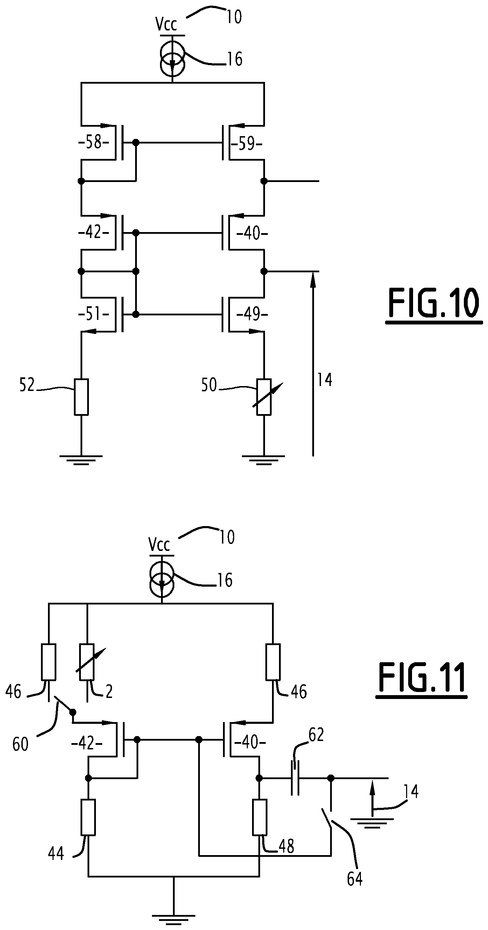

La Figure 10 illustre un quatrième mode de réalisation de l'invention, qui est une variante de circuit de la Figure 9, dans lequel la résistance 52 est constante et les résistances variables 2 et 46 sont remplacées respectivement par deux transistors MOS 58 et 59.

Les circuits décrits en référence aux Figures 3 à 9 permettent de réduire la consommation en courant du capteur par rapport au circuit classique de la Figure 1 d'un facteur d'au moins 35 tout en conservant des performances en résolution (bruit) et en gain acceptables.

Ces circuits peuvent fonctionner dans une multitude d'applications.

Les critères principaux permettant de différencier les capteurs piézorésistifs sont la sensibilité et la bande passante. En effet, si l'on fait l'hypothèse que l'on est en présence d'un stimulus physique constant en amplitude de fréquence quelconque, un capteur avec une sensibilité élevée permet d'obtenir un plus grand signal de sortie, se traduisant par un meilleur rapport signal sur bruit. Si le rapport signal sur bruit est suffisamment grand, l'étude en bruit des différents circuits proposés peut être négligée. Ainsi les structures proposées peuvent être utilisées sans aucune modification majeure. A l'inverse un capteur possédant une faible sensibilité produira un signal de sortie plus petit, et l'étude en bruit devient indispensable. Le niveau de bruit est proportionnel à la bande passante, et la nature du bruit intrinsèque de l'électronique est différente selon les bandes de fréquence étudiées. En effet le bruit intrinsèque de l'électronique se distingue par deux types de bruit distincts : le bruit blanc qui a une amplitude constante sur toute la bande de fréquences, et le bruit en excès (appelé bruit en 1/f) qui est inversement proportionnel à la fréquence.

Ainsi, il est nécessaire en basses fréquences de prévoir des moyens de diminution du bruit en 1/f dans les circuits de conditionnement proposés.

Parmi les dispositifs basse-fréquences, on peut compter un grand nombre d'applications et plus particulièrement les capteurs de pression ou d'accélération ou d'inclinaison. Pour ces applications, il est alors indispensable d'utiliser des moyens de modulation de type amplification par stabilisation à découpage ou modulation de courant dans l'élément sensible par exemple ou bien d'échantillonnage de type double-échantillonnage corrélé CDS (« Correlated Double Sampling ») afin de minimiser l'impact du bruit dans les basses fréquences. Une première mise en oeuvre de moyens d'échantillonnage appliquée à la structure de la Figure 5 peut être réalisée en utilisant la structure de la Figure 11.

Le circuit de l'état de la technique de la Figure 11 comprend des moyens d'échantillonnage ou de commutation permettant la réduction du bruit dans les basses fréquences. Dans ce circuit, la source du transistor 42 est raccordée à un commutateur 60 pouvant commuter entre la résistance variable 2 et la résistance de référence 46.

Le circuit comprend également un condensateur 62 raccordé au drain du transistor 40 et à un deuxième commutateur 64 lui-même raccordé à la grille du transistor 40.

Selon ce circuit, l'échantillonnage mis en oeuvre est un échantillonnage de type double-échantillonnage corrélé CDS.

Le principe de cet échantillonnage est basé sur le fait qu'en prenant une fréquence d'échantillonnage assez élevée, le bruit en 1/f est considéré comme une tension continue, c'est-à-dire un décalage (ou offset). En éliminant ce décalage, le bruit en 1/f est éliminé.

Le circuit de la Figure 11 fonctionne selon deux phases. Dans la première phase, le commutateur 60 est raccordé à la résistance de référence 42 et le condensateur 62 est raccordé à la masse analogique (point de polarisation) du circuit. Dans cette phase, il y a ainsi lecture de la tension de décalage.

Dans la deuxième phase, le commutateur 60 est raccordé à la résistance variable 2 et la tension de décalage est éliminée, ce qui réduit fortement le bruit en 1/f.

Il existe néanmoins un problème quant à la mise en oeuvre d'un échantillonnage dans le circuit de la Figure 11 lorsque le gain du circuit est élevé. En effet, lorsque le gain du circuit est élevé, la tension de décalage amènera le circuit en saturation.

Un mode de réalisation de l'invention consiste alors à réaliser un échantillonnage CDS en entrée du circuit de la Figure 6 à titre d'exemple.

Un autre mode de réalisation de l'invention, qui permet de réduire l'impact du bruit en 1/f des transistors du circuit, consiste à mettre en oeuvre une technique de modulation en amplitude du signal représentant la variation de résistance.

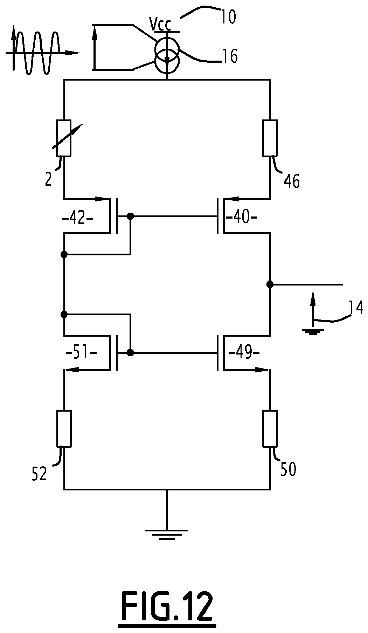

Ce mode de réalisation est décrit en référence à la Figure 12 qui illustre la mise en oeuvre d'une technique de modulation en amplitude sur le circuit de la Figure 6.

Selon un mode de réalisation, le générateur de courant constant 16 est remplacé par une source sinusoïdale de courant. Ceci a pour effet de multiplier le courant sinusoïdal au signal utile du capteur ce qui permet une modulation d'amplitude. Le spectre du signal utile est ainsi déplacé dans de plus hautes fréquences où le bruit en 1/f devient négligeable.

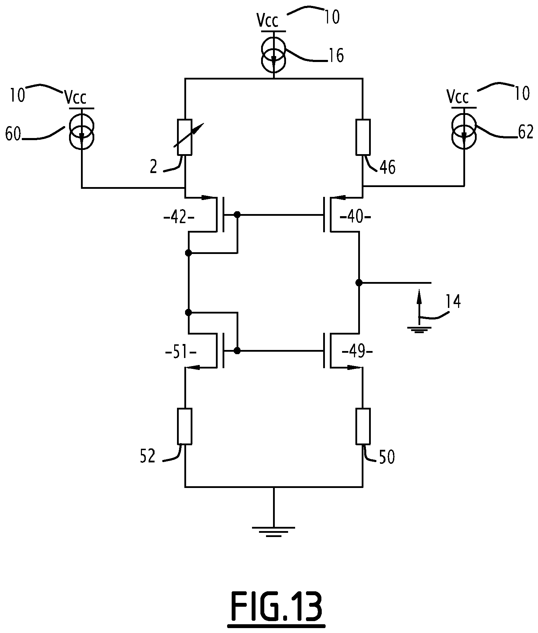

La Figure 13 illustre un mode de réalisation de l'invention dans lequel le générateur de courant 16 est remplacé par deux générateurs de courant 60 et 62 contrôlables générant respectivement deux courants I₁ et I₂ de faible intensité. Ce circuit permet de réduire la valeur du décalage de tension (offset) équivalent en entrée grâce à la mise en oeuvre d'un système de contre-réaction à générateurs de courants pondérés.

Le circuit à contre-réaction de la Figure 13 permet ainsi d'avoir un point de polarisation et un gain stables du circuit.

D'autres variantes du circuit à contre-réaction de la Figure 13 sont également envisageables. A titre d'exemples non limitatifs, il est possible d'utiliser des résistances ou des transistors au lieu des générateurs de courant.

Ainsi, l'invention permet une réduction intrinsèque de la consommation globale des circuits de conditionnement des capteurs résistifs et piézorésistifs permettant leur utilisation dans un spectre d'applications plus large que celui existant.

Les circuits décrits en référence aux Figures 3 à 13 peuvent être utilisés avec différents types de capteurs dans différentes plages de fréquences, à savoir :
- des capteurs basses fréquences en bande étroite (0Hz -100Hz) : capteurs de température, de pression, d'inclinaison ou d'accélération (inertiels) ;
- des capteurs basses fréquences à large bande (100 Hz - 4 kHz) : applications audio (microphones) ; ou
- des capteurs résonnants en bande étroite (≥ 20 kHz) : capteurs de champ magnétique.

Dans toutes ces applications, l'invention permet, outre la réduction de la consommation en courant des circuits, une augmentation du niveau de signal de sortie améliorant ainsi l'amplification du signal du capteur.

Bien entendu, d'autres modes de réalisation encore peuvent être envisagés.

## Revendications

1. Circuit d'amplification d'un signal représentant une variation de résistance d'une résistance variable (2) sensible à une grandeur physique à mesurer,
comportant au moins une première charge (49, 50) raccordée à l'électrode de sortie d'un premier transistor (40), l'électrode d'entrée du premier transistor (40) étant raccordée directement à une résistance de référence (46), et un second transistor dont l'électrode d'entrée est raccordée directement à la résistance variable (2) et dont l'électrode de sortie est raccordée à une deuxième charge (51, 52), de manière à permettre la récupération du signal amplifié (14) aux bornes de la première charge (49, 50),
**caractérisé en ce que** l'électrode de commande du premier transistor (40) est raccordée, à la fois, directement à l'électrode de commande et directement à l'électrode de sortie du deuxième transistor (42),
et **en ce que** la première charge (49, 50 ; 49, 54) comporte un troisième transistor (49) dont l'électrode de sortie est raccordée à l'électrode de sortie du premier transistor (40), et la deuxième charge (51 ; 52 ; 51, 56) comporte un quatrième transistor (51) dont l'électrode de sortie est raccordée à l'électrode de sortie du deuxième transistor (42), l'électrode de commande du troisième transistor (49) étant raccordée, à la fois, directement à l'électrode de commande et directement à l'électrode de sortie du quatrième transistor (51),
l'électrode d'entrée, respectivement de sortie, correspondant soit à la source, respectivement au drain, du transistor associé pour un transistor à effet de champ, soit à l'émetteur, respectivement au collecteur, du transistor associé pour un transistor bipolaire.

2. Circuit d'amplification selon la revendication 1, **caractérisé en ce que** le premier et le second transistors sont des transistors à effet de champ MOS (40, 42) ou des transistors bipolaires.

3. Circuit d'amplification selon la revendication 1 ou 2, **caractérisé en ce que** la résistance de référence (46) est également une résistance variable.

4. Circuit d'amplification selon l'une quelconque des revendications 1 à 3, **caractérisé en ce que** chacune de la première charge (49, 50) et de la deuxième charge (51, 52) comporte au moins une résistance (50, 52).

5. Circuit d'amplification selon la revendication 4, **caractérisé en ce que** les résistances (50, 52) de la première charge (49, 50) et de la deuxième charge (51, 52) sont des résistances variables.

6. Circuit d'amplification selon l'une quelconque des revendications 1 à 5, **caractérisé en ce que** chacune de la première charge (49, 54) et de la deuxième charge (51, 56) comporte deux transistors (54, 56).

7. Circuit d'amplification selon l'une quelconque des revendications 1 à 6, **caractérisé en ce qu'**il comporte des moyens d'échantillonnage ou de commutation (60, 62) du signal représentant la variation de résistance, pour réduire le bruit en basses fréquences du circuit.

8. Circuit d'amplification selon la revendication 7, **caractérisé en ce que** les moyens d'échantillonnage (60, 62) permettent la mise en oeuvre d'un double échantillonnage corrélé du signal représentant la variation de résistance

9. Circuit d'amplification selon l'une quelconque des revendications 1 à 8, **caractérisé en ce qu'**il comporte des moyens de modulation d'amplitude (16) du signal représentant la variation de résistance pour réduire l'impact du bruit en basses fréquences des transistors (40 , 42 , 49 , 51, 54, 56) dudit circuit.

10. Circuit d'amplification selon l'une quelconque des revendications 1 à 9, **caractérisé en ce qu'**il comporte des moyens de contre-réaction (60, 62) pour stabiliser le point de polarisation et le gain dudit circuit.

11. Circuit d'amplification selon l'une quelconque des revendications 1 à 10, **caractérisé en ce que** le premier, le second, le troisième et le quatrième transistors sont des transistors à effet de champ MOS (40, 42, 49, 51) ou des transistors bipolaires.

12. Capteur, **caractérisé en ce qu'**il comporte un circuit d'amplification selon l'une quelconque des revendications 1 à 11.

13. Capteur selon la revendication 12, **caractérisé en ce qu'**il est choisi dans le groupe comportant :
- un capteur piézorésistif ;
- un capteur de pression ;
- un capteur de température ;
- un capteur d'accélération ;
- un capteur d'inclinaison ;
- un microphone ; et
- un capteur de champ magnétique.

## Patentansprüche

1. Schaltung zum Verstärken eines Signals, das eine Widerstandsänderung eines variablen Widerstands (2) repräsentiert, der gegenüber einer zu messenden physikalischen Größe sensibel ist,
aufweisend mindestens eine erste Last (49, 50), die mit der Ausgangselektrode eines ersten Transistors (40) verbunden ist, wobei die Eingangselektrode des ersten Transistors (40) direkt mit einem Referenzwiderstand (46) verbunden ist und einen zweiten Transistor, dessen Eingangselektrode direkt mit dem variablen Widerstand (2) verbunden ist und dessen Ausgangselektrode mit einer zweiten Last (51, 52) verbunden ist, in der Art, dass die Rückgewinnung des verstärkten Signals (14) an den Anschlüssen der ersten Last (49, 50) ermöglicht wird,
dadurch charakterisiert, dass die Steuerelektrode des ersten Transistors (40) zugleich direkt mit der Steuerelektrode und direkt mit der Ausgangselektrode des zweiten Transistors (42) verbunden ist,
und dadurch, dass die erste Last (49, 50; 49, 54) einen dritten Transistor (49) aufweist, dessen Ausgangselektrode mit der Ausgangselektrode des ersten Transistors (40) verbunden ist und die zweite Last (51; 52; 51, 56) einen vierten Transistor (52) aufweist, dessen Ausgangselektrode mit der Ausgangselektrode des zweiten Transistors (42) verbunden ist, wobei die Steuerelektrode des dritten Transistors (49) zugleich direkt mit der Steuerelektrode und direkt mit der Ausgangselektrode des vierten Transistors (52) verbunden ist,
wobei die Eingangselektrode bzw. die Ausgangselektrode der Source bzw. dem Drain des zugehörigen Transistors für einen Feldeffekttransistor und dem Emitter bzw. dem Kollektor des zugehörigen Transistors für einen Bipolartransistor entspricht.

2. Schaltung zum Verstärken gemäß Anspruch 1, dadurch charakterisiert, dass der erste Transistor und der zweite Transistor MOS-Feldeffekttransistoren (40, 42) oder Bipolartransistoren sind.

3. Schaltung zum Verstärken gemäß Anspruch 1 oder 2, dadurch charakterisiert, dass der Referenzwiderstand (46) ebenso ein variabler Widerstand ist.

4. Schaltung zum Verstärken gemäß einem der Ansprüche 1 bis 3, dadurch charakterisiert, dass jede der ersten Last (49, 50) und der zweiten Last (51, 50) mindestens einen Widerstand (50, 52) aufweist.

5. Schaltung zum Verstärken gemäß Anspruch 4, dadurch charakterisiert, dass die Widerstände (50, 52) der ersten Last (49, 50) und der zweiten Last (51, 52) variable Widerstände sind.

6. Schaltung zum Verstärken gemäß einem der Ansprüche 1 bis 5, dadurch charakterisiert, dass jede der ersten Last (49, 54) und der zweiten Last (51, 56) zwei Transistoren (54, 56) aufweist.

7. Schaltung zum Verstärken gemäß einem der Ansprüche 1 bis 6, dadurch charakterisiert, dass sie Mittel zum Abtasten oder Schalten (60, 62) des Signals, das die Widerstandsänderung repräsentiert, aufweist, um das Rauschen der Schaltung bei tiefen Frequenzen zu reduzieren.

8. Schaltung zum Verstärken gemäß Anspruch 7, dadurch charakterisiert, dass die Abtastmittel (60, 62) das Durchführen einer korrelierten Doppelabtastung des Signals, das die Widerstandsänderung repräsentiert, ermöglichen.

9. Schaltung zum Verstärken gemäß einem der Ansprüche 1 bis 8, dadurch charakterisiert, dass es Mittel zur Modulation der Amplitude (16) des Signals, das die Widerstandsänderung repräsentiert, aufweist, um den Einfluss des Rauschens bei niedrigen Frequenzen der Transistoren (40, 42, 49, 51, 54, 56) der Schaltung zu reduzieren.

10. Schaltung zum Verstärken gemäß einem der Ansprüche 1 bis 9, dadurch charakterisiert, dass es Mittel zur Gegenreaktion (60, 62) zum Stabilisieren des Arbeitspunkts und der Verstärkung der Schaltung aufweist.

11. Schaltung zum Verstärken gemäß einem der Ansprüche 1 bis 10, dadurch charakterisiert, dass der erste, der zweite, der dritte und der vierte Transistor MOS-Feldeffekttransistoren (40, 42, 49, 51) oder Bipolartransistoren sind.

12. Sensor, dadurch charakterisiert, dass er eine Schaltung zum Verstärken gemäß einem der Ansprüche 1 bis 11 aufweist.

13. Sensor gemäß Anspruch 12, dadurch charakterisiert, dass er aus der Gruppe ausgewählt ist aufweisend:
- einen Piezo-Widerstand-Sensor;
- einen Drucksensor;
- einen Temperatursensor;
- einen Beschleunigungssensor;
- einen Neigungssensor;
- ein Mikrophon; und
- einen Magnetfeldsensor.

## Claims

1. Amplification circuit for amplifying a signal representing a variation in resistance of a variable resistor (2) sensitive to a physical quantity to be measured, comprising at least one first load (49, 50) connected to the output electrode of a first transistor (40), the input electrode of the first transistor (40) being connected directly to a reference resistor (46), and a second transistor, the input electrode thereof being connected directly to the variable resistor (2) and the ooutput electrode thereof being connected to a second load (51, 52), so as to allow the recovery of the amplified signal (14) at the terminals of the first load (49, 50),
**characterised in that** the command electrode of the first transistor (40) is connected both directly to the command electrode and directly to the output electrode of the second transistor (42),
and **in that** the first load (49, 50; 49, 54) comprises a third transistor (49), the output electrode thereof being connected to the output electrode of the first transistor (40), and the second load (51; 52; 51, 56) comprises a fourth transistor (51), the output electrode thereof being connected to the output electrode of the second transistor (42), the command electrode of the third transistor (49) being connected, both, directly to the command electrode and directly to the output electrode of the fourth transistor (51),
the input electrode, respectively the output electrode, corresponding either to the source, respectively the drain, of the associated transistor for a field effect transistor, or to the emitter, respectively the collector, of the associated transistor for a bipolar transistor.

2. Amplification circuit according to claim 1, **characterised in that** the first and second transistors are MOS field effect transistors (40, 42) or bipolar transistors.

3. Amplification circuit according to claim 1 or 2, **characterised in that** the reference resistor (46) is also a variable resistor.

4. Amplification circuit according to any one of claims 1 to 3, **characterised in that** each of the first load (49, 50) and the second load (51, 52) comprises at least one resistor (50, 52).

5. Amplification circuit according to claim 4, **characterised in that** the resistors (50, 52) of the first load (49, 50) and of the second charge (51, 52) are variable resistors.

6. Amplification circuit according to any one of claims 1 to 5, **characterised in that** each of the first load (49, 54) and the second load (51, 56) comprises two transistors (54, 56).

7. Amplification circuit according to any one of claims 1 to 6, **characterised in that** it comprises means (60, 62) for sampling or switching the signal representing the variation in resistance, so as to reduce the low-frequency noise of the circuit.

8. Amplification circuit according to claim 7, **characterised in that** the means (60, 62) implements a correlated double sampling of the signal representing the variation in resistance.

9. Amplification circuit according to any one of claims 1 to 8, **characterised in that** it comprises means (16) for modulating the amplitude of the signal representing the variation in resistance, so as to reduce the impact of the low-frequency noise of the transistors (40, 42, 49, 51, 54, 56) of said circuit.

10. Amplification circuit according to any one of claims 1 to 9, **characterised in that** it comprises feedback means (60, 62) for stabilizing the bias point and the gain of said circuit.

11. Amplification circuit according to any one of claims 1 to 10, **characterised in that** the first, the second, the third and the fourth transistors are MOS field effect transistors (40, 42, 49, 50) or bipolar transistors.

12. Sensor, **characterised in that** it comprises an amplification circuit according to any one of claims 1 to 11.

13. Sensor according to claim 12, **characterised in that** it is selected from the group comprising:
- a piezoresistive sensor;
- a pressure sensor;
- a temperature sensor;
- an acceleration sensor;
- an inclination sensor;
- a microphone; and
- a magnetic field sensor.
